# EUROPEAN PATENT SPECIFICATION

(11) **EP 4 364 949 B1**
(45) Date of publication and mention of the grant of the patent: **24.09.2025**
(21) Application number: 23202540.3
(22) Date of filing: 09.10.2023
(51) Int. Cl.: B41F 15/18, B41F 15/08, H01L 21/677, H01L 21/68, H05K 3/12

(54) **REFERENCING SYSTEM FOR SINGULATED WORKPIECES**
REFERENZIERSYSTEM FÜR VEREINZELTE WERKSTÜCKE
SYSTÈME DE RÉFÉRENCEMENT POUR PIÈCES À USINER SÉPARÉES

(30) Priority: 01.11.2022 GB 202216231
(43) Date of publication of application: 08.05.2024
(73) Proprietor: ASMPT SMT Singapore Pte. Ltd., Singapore 768924 (SG)
(72) Inventor: Short, Neil, Weymouth, DT4 0BE (GB)
(74) Representative: Emerson, Peter James

(56) References cited:
- WO-A1-2014/083605
- WO-A1-2018/193773
- US-A1- 2016 039 196

## Description

This invention relates to tooling for supporting a plurality of singulated workpieces during a printing operation, a printer for printing print medium onto a plurality of singulated workpieces during a printing operation, and a method of referencing a plurality of singulated workpieces within a printer prior to performing a printing operation.

### Background and Prior Art

Industrial screen-printing machines typically apply a conductive print medium, such as solder paste, silver paste or conductive ink, onto one or more planar workpieces, such as circuit boards, by applying the conductive print medium through a pattern of apertures in a thin planar layer or mask, such as a stencil (which is a patterned solid material such as stainless steel) or a screen which is a mesh material coated with emulsion. The present invention is equally applicable to both screen and stencil printing, and for convenience the term "stencil" will be used to refer to any such patterned mask throughout the remainder of this document. The print medium is applied using an angled blade or squeegee. The same machines may also be used to print certain non-conductive media, such as glue or other adhesive, onto workpieces.

When printing a plurality of individual "singulated" workpieces in a single printing operation, it is necessary to support each workpiece individually, while permitting the workpieces to be aligned within their plane, i.e. the horizontal plane in standard printing machines. Typically, it is also necessary for the supports to be referenced in the vertical or Z direction.

Such alignment systems are known from WO2018/193773A1, in which workpieces are sequentially aligned by a member which picks them up from above, and WO2014/083605A1 which uses a purely horizontal referencing system.

A system for supporting singulated workpieces is known from WO2014/166956A1 for example. This system uses a plurality of towers, one for each singulated workpiece, arranged in an array on top of a vertically-movable tooling table. Each tower has a head section at its distal end which can be moved in the horizontal plane relative to the rest of the tower, and this movement is created by the action of a separate horizontal referencing plate (sometimes known as an "active surround"), during a horizontal referencing operation. Each tower is also lockably deformable in the Z direction. To achieve Z referencing, a vertical referencing operation is performed in which the towers are raised up by the tooling table so that the towers engage with the underside of a vertical referencing plate (sometimes known as a "top reference plate" or TRP), deform, and are then locked to the referenced Z height (sometimes known as "Z-locking"). The top reference plate clearly needs to be moved away from the tooling so that it does not interfere with a subsequent printing operation.

While this system works well, there are drawbacks. In particular, the TRP has to be a large, rigid structure capable of absorbing the combined upwards forces of all of the towers, which may be significant. For example, each tower may apply up to around 1 kg of upward force. This in turn necessitates relatively large components to move the top reference plate into and out of its referencing position above the towers. In addition, the Z-locking system must hold each tower to withstand a downward force of around 3 to 5kg, due to the pressure applied by the squeegee during the printing operation. The size and weight of these components is therefore large, and it is desirable to reduce these, without adversely affecting reliability or accuracy.

The present invention seeks to overcome these problems, and provide a tooling system with greatly reduced weight and size.

In accordance with the present invention this aim is achieved in a two-fold manner:
i) a new type of Z-actuation and locking mechanism is proposed for the towers, greatly reducing the weight, size and Z-forces produced; and
ii) the need for a separate top reference plate is dispensed with entirely, by utilising the active surround for top referencing.

In this way, a single referencing plate may be used both for horizontal and vertical referencing operations.

### Summary of the Invention

In accordance with a first aspect of the present invention there is provided tooling or supporting a plurality of singulated workpieces during a printing operation, the tooling comprising a plurality of towers, each tower extending along an axis and configured to support a respective workpiece of the plurality of workpieces in a horizontal orientation, each tower comprising:
a body,
a head with a support surface provided at a distal end of the head and configured to support the respective workpiece thereon, the support surface being displaceable relative to the body in a plane perpendicular to the axis, and
wherein the body comprises a pneumatic input to receive pressurised air and provide a lifting force to the head to move it along the axis relative to the body, and
wherein each tower comprises a locking mechanism for selectively locking the head relative to the body.

In accordance with a second aspect of the present invention there is provided a printer for printing print medium onto a plurality of singulated workpieces during a printing operation, comprising the tooling of the first aspect.

In accordance with a third aspect of the present invention there is provided a method of referencing a plurality of singulated workpieces within a printer prior to performing a printing operation, the printer comprising tooling according to the first aspect for supporting the singulated workpieces thereon and a referencing plate having a plurality of referencing surfaces movable within a horizontal plane, the method comprising the steps of:
i) supporting the workpieces on the tooling in a horizontal orientation, and
ii) performing, in any order, a vertical referencing operation and a horizontal referencing operation,
   the vertical referencing operation comprising lifting the supported workpieces into contact with an underside of the referencing plate, then locking the tooling to retain the supported workpieces at a locked vertical distance from a base of the tooling, and
   the horizontal referencing operation comprising lifting the supported workpieces into respective apertures provided in the referencing plate and moving the referencing surfaces within the horizontal plane into contact with respective supported workpieces.

Other specific aspects and features of the present invention are set out in the accompanying claims.

### Brief Description of the Drawings

The invention will now be described with reference to the accompanying drawings (not to scale), in which:
FIG. 1 schematically shows a sectional side view of tooling in accordance with an embodiment of the present invention, located beneath a referencing plate;
FIGs. 2A-2C schematically show a sectional side view of a tower at various stages during a vertical referencing operation; and
FIGs. 3A-3S schematically show stages in a referencing method in accordance with an embodiment of the present invention.

### Detailed Description of the Preferred Embodiments of the Invention

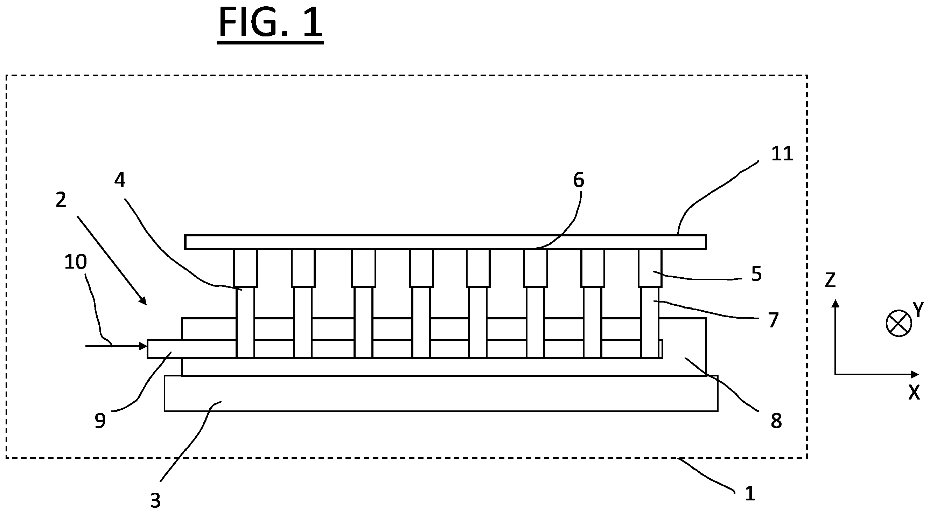

An embodiment of the present invention is schematically shown in FIG. 1. A printer 1 is shown fitted with tooling 2, which is supported on a rising table 3 of the printer 1. Although not shown for clarity, it will be understood that the tooling 2 is thus located below a printing area of the printer 1, such that a stencil may be located above the tooling 2 which may acted upon by a squeegee of a print head during a printing operation. In use (and as is well-known in the art per se), a plurality of unprinted workpieces (not shown in FIG. 1) may enter the printer 1 in a carrier (not shown) to overlie the tooling 2. The rising table 3 may then be driven vertically upwards (i.e. parallel to the positive Z direction shown) to raise the unprinted workpieces from the carrier and into contact with the stencil for the printing operation. Following completion of the printing operation, the rising table 3 may then be lowered to move the printed workpieces away from the stencil and back to the carrier, for further transport out of the printer 1.

The tooling 2 comprises a plurality of vertically-orientated towers 4, i.e. each tower extends parallel to the Z-axis, with each tower 4 configured to support a respective workpiece (not shown) of the plurality of workpieces in a horizontal orientation. Each tower 4 comprises a head 5 and a body 7 which supports the head 5, with the body being supported on a base 8 of the tooling 2, which is common to all of the towers 4. The head 5 has a respective support surface 6 at a distal end thereof which is configured to support the respective workpiece thereon. The support surface 6 is displaceable relative to the body 7 in a plane perpendicular to the axis, i.e. parallel to the horizontal X-Y plane shown. This displaceability may be achieved in a variety of ways. For example, in the previously-mentioned WO2014/166956A1 the support surface 6 is connected to its tower via a resiliently deformable material such as rubber or other elastomeric material. As described in more detail below, this displaceability enables the support surface 6 and its respective workpiece to be displaced away from a 'neutral' X-Y position by a referencing plate 11 during a horizontal referencing operation, and then return to the neutral position when the referencing plate 11 disengages after the horizontal referencing operation. With the tooling 2, the support surface 6 could for example be connected to its head 5 via a resiliently deformable material (not shown), or the head 5 could be connected to the body 7 via a resiliently deformable material, or an alternative arrangement (for example using springs rather than a resiliently deformable material) could be provided as will be apparent to those skilled in the art.

In addition, the head 5 is moveable relative to the body 7, in a direction parallel to the Z axis, i.e. vertically. In order to control this vertical movement of the head 5, the body 7 comprises a pneumatic input to receive pressurised air and provide a lifting force to the head 5 to move it vertically upwards, relative to the body 7. The pressurised air is passed to the body 7 of each tower 4 via an air channel 9 provided in the base 8, which connects to a pneumatic supply 10, such as a pump (not shown). In this way, air may be supplied to each tower 4, to lift each head 5 into contact with the underside of the referencing plate 11, as shown in FIG. 1, during a vertical referencing operation, as will be described in more detail below. Each tower 4 also comprises a locking mechanism (not shown in FIG. 1), for selectively locking the head 5 relative to the body 7. The locking mechanism may be applied in the position shown in FIG. 1, to lock the head 5 of each tower 4 in a vertically referenced position set by the underside of the referencing plate 11, such that the head 5 remains in that position when the towers 4 and referencing plate 11 are moved apart, as will be described in more detail below.

Although not shown in FIG. 1, each tower may also comprise means for adhering a workpiece onto the support surface 6, such as a vacuum or relatively low pressure source, as is known in the art per se and so need not be described in detail here.

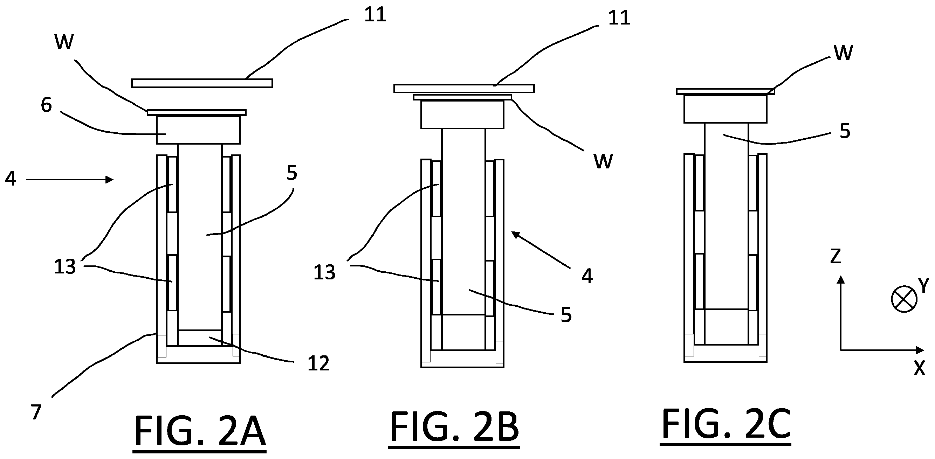

FIGs. 2A-2C schematically show a sectional side view of a tower 4 at various stages during a vertical referencing operation, illustrating a locking mechanism in accordance with an embodiment of the present invention. As shown, in this embodiment the head 5 comprises an elongate stem extending along the axis of the tower 4, i.e. parallel to the Z-axis, with the support surface 6 at its uppermost end. The body 7 comprises a sleeve having a central aperture dimensioned to slidingly receive the stem therein along the axis. Pressurised air from the pneumatic supply 10 (see FIG. 1) may be selectively introduced into a lift cavity 12 at the bottom of the sleeve, under the stem, via a pneumatic port (not shown). An air bearing 13 is provided in the aperture adjacent to the stem, such that when an air supply is supplied to the air bearing, via a separate air passage (not shown), friction between the stem and the air bearing is reduced, so that the stem may slide relative to the air bearing 13 parallel to the axis. When the air supply is not supplied to the air bearing 13, the stem is locked relative to the air bearing 13. In more detail, the sleeve is dimensioned so that, in the absence of an air supply to the air bearing 13, the stem is held tightly by the air bearing 13. However, when air is supplied to the air bearing 13, the sleeve is slightly deformed outwardly, permitting the stem to travel, with the thus activated air bearing 13 reducing or substantially eliminating friction. As a result, the head 5 can be lifted by applying only a very small upward force via the lift cavity 12. When the air supply is again removed to the air bearing 13, the sleeve contracts and the stem is locked relative to the air bearing, and hence sleeve.

In FIG. 2A, the head 5 is shown at or near its lowest limit of vertical movement relative to the body 7. A workpiece W supported on support surface 6 underlies the referencing plate 11. FIG. 2B shows the same tower 4 following lifting of the head 5 by applying air both to the lift cavity 12 and to the air bearing 13. The head 5 "floats" upwards until the workpiece W contacts the underside of the referencing plate 11. At this point, air supply to the air bearing 13 is removed to lock the head 5 relative to the body 7, and, optionally, air supply to the lift cavity may also be removed. As shown in FIG. 2C, when if the referencing plate 11 is moved away from the workpiece W, the head 5 remains in its locked position.

The use of a lifting pressure, through providing an air supply to the lift cavity 12, as opposed to using a lift spring (as in known systems) maintains a constant upwards force. This removes the need to factor in spring max / min values during design and further reduces the maximum force which must be borne by the referencing plate. Therefore, the referencing plate 11 can be significantly thinner, and hence lighter, than conventional top referencing plates. As described in more detail below, this improvement permits a common, relatively thin, referencing plate to be used both for vertical referencing and horizontal referencing operations.

Furthermore, the use of a compliant body as described above may have an additional benefit of removing the need for high machining tolerances.

There is flexibility in the design of such towers. For example, the stems could have square cross-sections, in which case the air bearings could be planar, so as to be contiguous with at least two opposing sides of the stem. Alternatively for example, the stems could have circular cross-sections, in which case the air bearings may be annular, completely surrounding the stem.

In an alternative embodiment, which is otherwise very similar to that shown in FIGs. 2A-C, the sleeve may be dimensioned so that, in the absence of an air supply to the air bearing 13 (or alternatively during application of a positive air pressure to the air bearing 13), a clearance between the air bearing 13 and stem is maintained, allowing relative movement therebetween. The subsequent application of negative pressure to the air bearing 13 will collapse the air bearing 13 to lock the stem relative to the air bearing 13.

In a further alternative embodiment, a separate locking component may be provided, which is actuable upon application of a negative pressure.

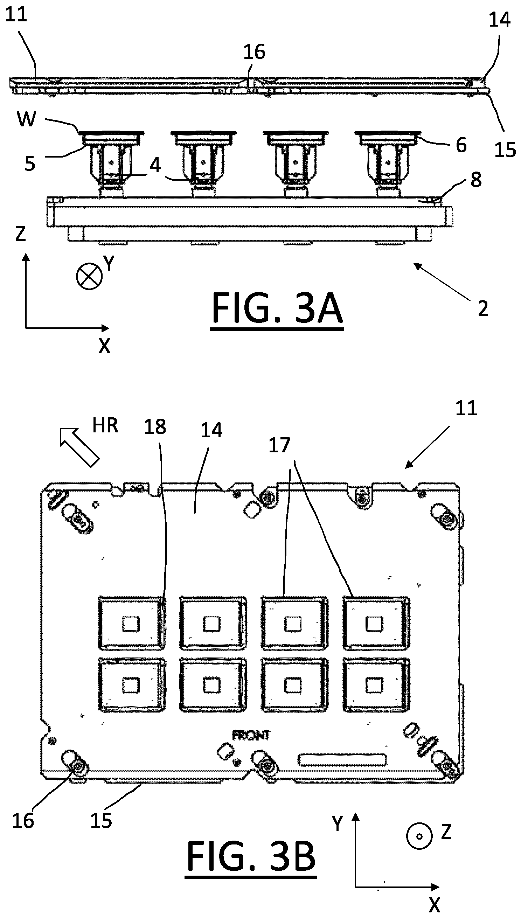

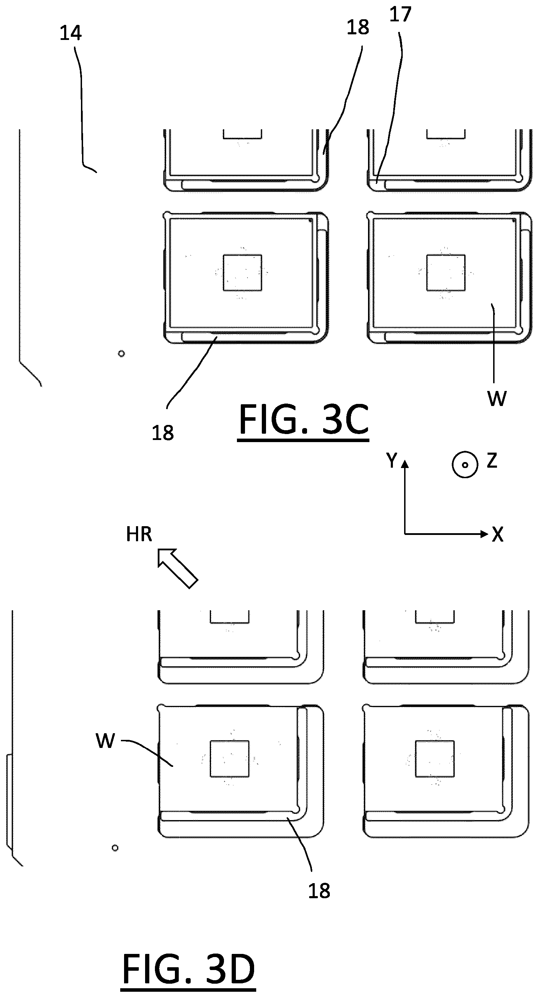

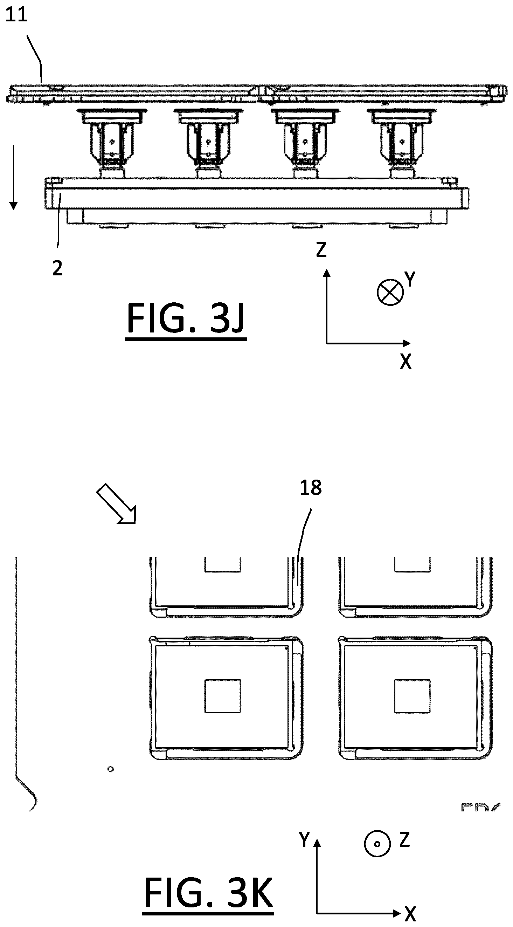

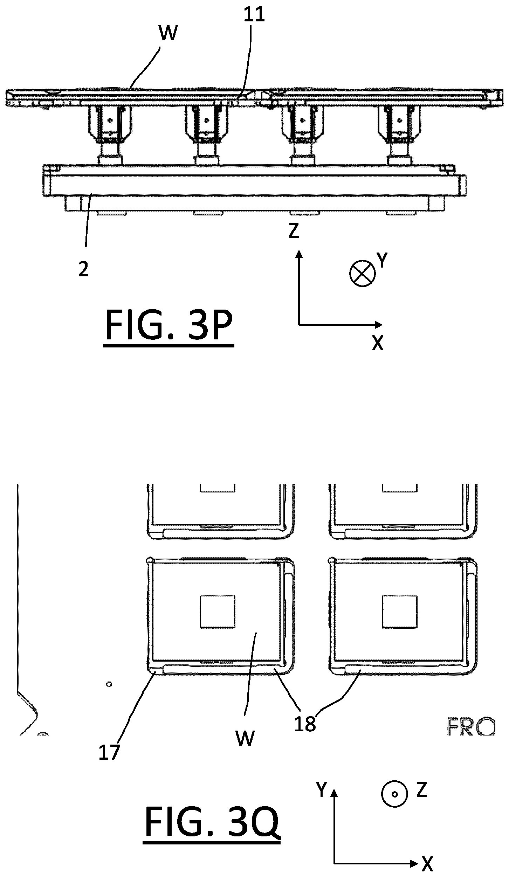

FIGs. 3A-3S schematically show stages in a referencing method in accordance with an embodiment of the present invention. In more detail, FIGs. 3A-3C show the tooling and referencing plate prior to performing any referencing, FIGs. 3D-3J show a vertical referencing operation, FIGs. 3K-3P show a horizontal referencing operation followed by a printing operation, while FIGs. 3Q-3S show the apparatus following the printing operation. For the sake of clarity, these figures only show the tooling 2 and referencing plate 11, and in particular the rising table upon which the tooling 2 would be supported, the carrier in which the workpieces W enter the printer, as well as the stencils and print head necessary for performing the printing operation, are omitted from these figures.

FIGs. 3A-3C show the tooling and referencing plate prior to performing any referencing, in a sectional side view, view from above, and enlarged view from above respectively. As shown, the tooling 2 comprises eight towers 4, arranged in a 4 x 2 array. Here, the support surface 6 of each tower 4 is connected to its respective head 5 via a resiliently deformable material (not visible) such as rubber, as previously described. The referencing plate 11 is shown in more detail than previously, and here it can be seen that the referencing plate 11 comprises an upper plate 14 and a lower plate 15 connected by fixings 16 so that they are held in parallel, horizontal (i.e. in the X-Y plane) configuration, but may move relative to each other in the horizontal (X-Y) plane. More particularly, the lower plate 15 may be moved parallel to a horizontal referencing direction HR, (shown in FIG. 3B) which is arranged at approximately 45° to the X and Y axes. An actuator (not shown) may be provided to move the lower plate 15 in the direction HR, and in the reverse direction, while the upper plate 14 returns stationary, as is known in the art per se. Apertures 17 are formed extending through the referencing plate 11, i.e. through both the upper plate 14 and the lower plate 15, which are arranged and dimensioned so that workpieces W supported on each tower 4 may be received therein, following lifting of the tooling 2, with sufficient clearance to allow for reasonable misalignments of the workpieces W on the towers 4. It can therefore be seen that when the lower plate 15 is moved in the direction HR, the right-hand and lower edges of the apertures 17 as shown move inwardly of the respective aperture 17, reducing its open area. These edges therefore act as referencing surfaces 18, so that, if a workpiece W is received within an aperture 17, as they move in direction HR, the referencing surfaces 18 will contact the workpiece W and impel it to move to the top-left corner of the aperture 17 as shown, i.e. into a horizontally-referenced position. As more clearly shown in FIG. 3C, the referencing surfaces 18 here are made larger in the Z direction by providing upwardly projecting "L-shaped" walls on the lower plate 15 at the lower and right-hand side of the apertures 17, which extend up into the apertures formed in the upper plate 14. For clarity, in the following discussion, the term "closing" will be used to describe the lower plate 15 moving in the direction HR to reduce the open area of the apertures 17, while the term "opening" will be used to describe the lower plate 15 moving in the direction opposite to HR, to increase the open area of the apertures 17.

Optionally, at least one of the upper and lower plates 14, 15 may be compliant, or allow for minor off axis translation on the horizontal plane. This compliance can be used to accommodate minor variances in both aperture dimensions and substrate dimensions.

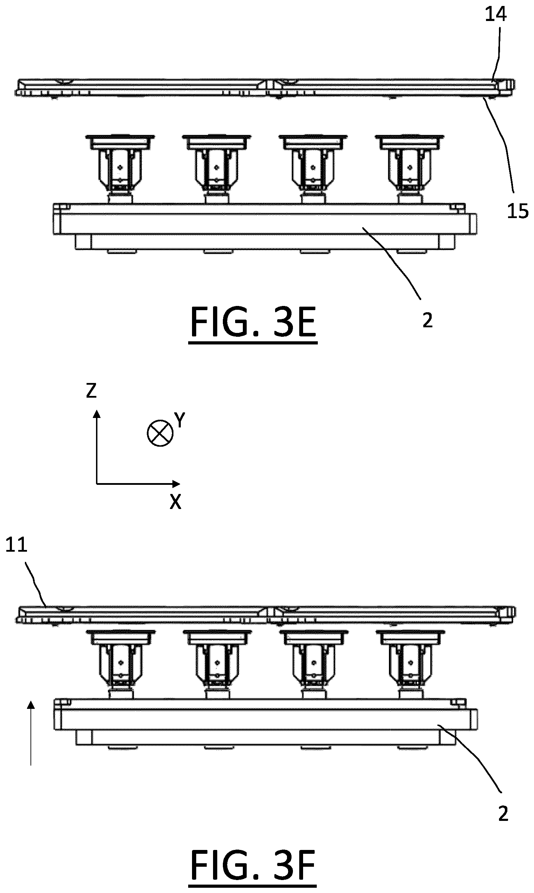

FIGs. 3D-3J show stages in a vertical referencing operation. Firstly, as shown in FIGs. 3D and 3E, with the tooling 2 in the lowered state (and as also shown in FIG. 3A), the apertures 17 are closed, by moving the referencing surfaces 18 in the direction HR. It should be noted that the workpieces W visible in FIG. 3D are visible through the apertures, but are not received therein.

Then, as shown in FIG. 3F, the tooling 2 is raised, by lifting the rising table (not shown), closer to the referencing plate 11, into a "pre-referencing position".

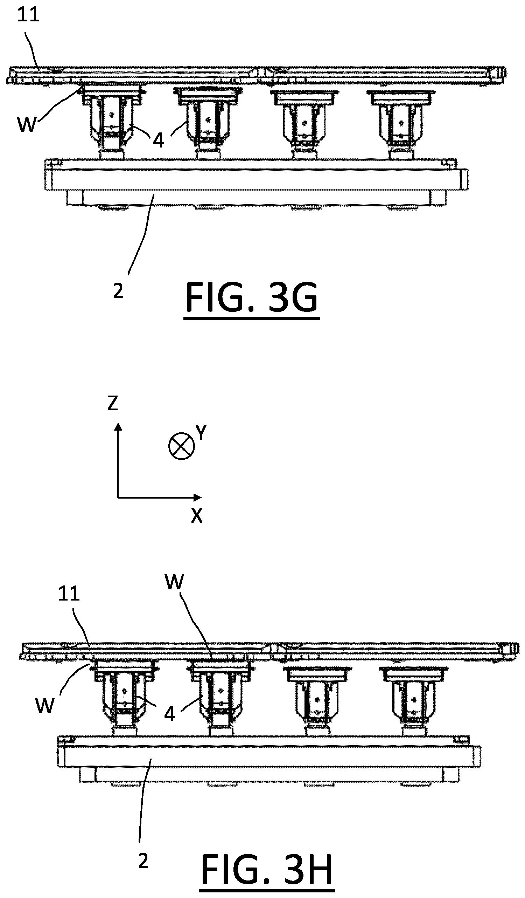

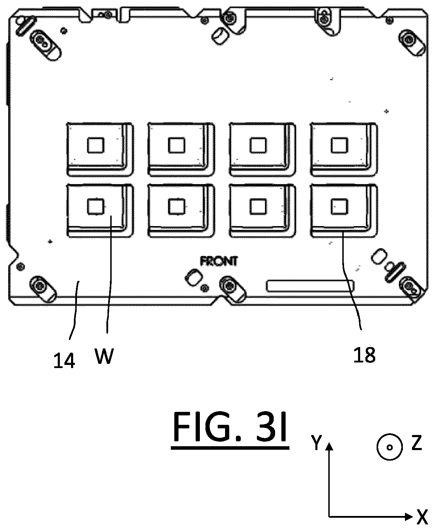

Next, as shown in FIGs. 3G to 3J, the workpieces W are lifted up to the referencing plate 11, by raising the head 5 of each tower 4 relative to the body 7, i.e. by supplying pneumatic air to the lifting cavity 12 (see FIG. 2). Once the workpieces W contact the underside of the referencing plate 11, they are prevented from further lifting. As shown in FIGs. 3G and 3H, this lifting may optionally be performed sequentially - in FIG. 3G only the left-most workpiece W has been lifted, while in FIG. 3H the two left-most workpieces W have been lifted - until all of the supported workpieces W have been so lifted. Such sequential lifting may be controlled by suitable control of the pneumatic supply to the towers 4, for example using pneumatic logic, serial connected air feeds, or other, well-known per se, control means. Sequential lifting may be advantageous to reduce the maximum upward impulse received by the referencing plate 11. As shown in FIG. 3I, the workpieces W are brought into contact with the underside of the referencing plate 11, in more detail they contact the underside of the lower plate 15 in the vicinity of the referencing surfaces 18, which are closing the apertures 17. This contact acts to vertically reference the workpieces W. When all of the workpieces W have been so referenced, the locking mechanisms of all towers 4 are engaged, for example by removing air supply to the air bearings 13 (see FIG. 2) or by applying negative pressure thereto. Then, as shown in FIG. 3J, the tooling 2 may be lowered, through movement of the rising table) so that the workpieces W no longer contact the referencing plate 11.

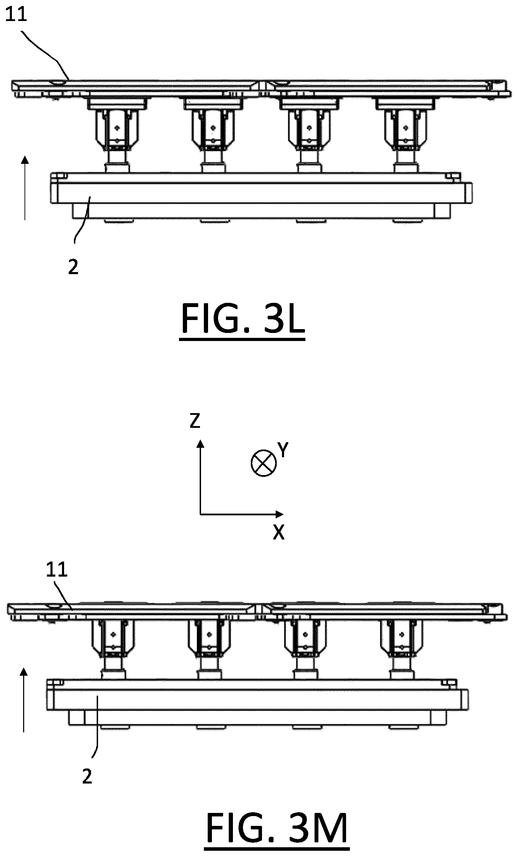

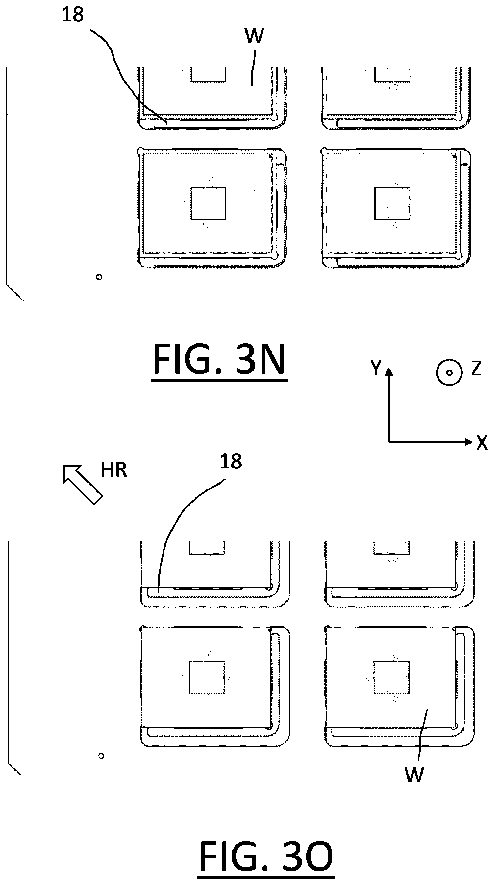

FIGs. 3K-3P show stages of a subsequent horizontal referencing operation, followed by a printing operation. As shown in FIG. 3K, the referencing surfaces 18 are moved to open the apertures 17. Then, as shown in FIGs. 3L and 3M, the tooling 2 is lifted towards the referencing plate 11, so that the workpieces W approach and are then received into apertures 17. Due to the previous vertical referencing, they project from the above the referencing plate 11 by the same, repeatable, distance. Once the workpieces W are fully received in the open apertures 17 (see FIG. 3N), the referencing surfaces 18 move in direction HR to close the apertures 17, as shown in FIGs. 3O, 3P. As described previously, this acts to horizontally reference the workpieces W. With the workpieces W now both vertically and horizontally referenced, they can undergo a printing operation.

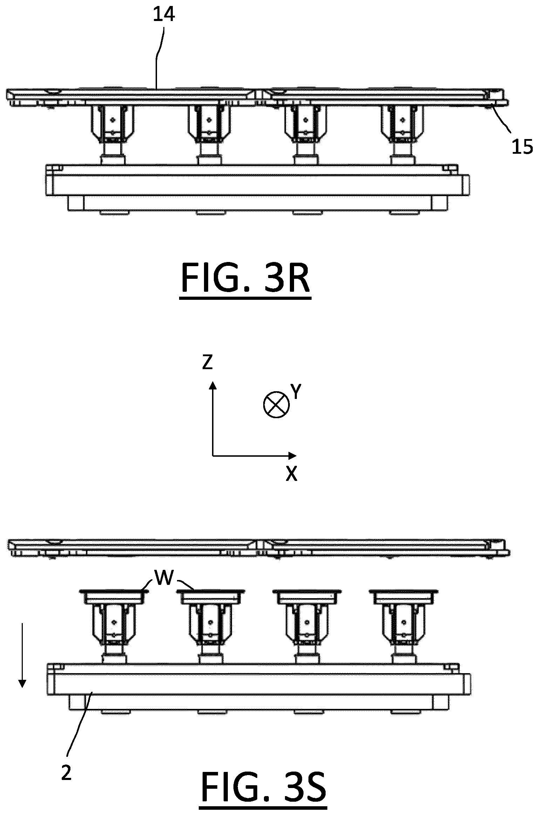

FIGs. 3Q-3S show the apparatus following the printing operation. As shown in FIGs. 3Q, 3R, following printing, the referencing surfaces 18 move to open the apertures 17. Finally, as shown in FIG. 3S, the tooling 2 may be lowered, through movement of the rising table, and the printed workpieces W can be returned to the carrier.

The above-described embodiments are exemplary only, and other possibilities and alternatives within the scope of the invention will be apparent to those skilled in the art. For example, while as described above the vertical referencing occurs before the horizontal referencing, this is not strictly necessary, if the towers are provided with means to lock the support surfaces in a referenced horizontal position.

### Reference numerals used:

1- Printer
2 - Tooling
3 - Rising table
4 - Towers
5 - Head
6 - Support surface
7 - Body
8 - Base
9 - Air channel
10 - Pneumatic supply
11 - Referencing plate
12 - Lift cavity
13 - Air bearing
14 - Upper plate
15 - Lower plate
16 - Fixings
17 - Apertures
18 - Referencing surfaces
HR - Horizontal referencing direction
W - Workpiece

## Claims

1. Tooling (2) for supporting a plurality of singulated workpieces (W) during a printing operation, the tooling (2) comprising a plurality of towers (4), each tower (4) extending along an axis and configured to support a respective workpiece (W) of the plurality of workpieces (W) in a horizontal orientation, each tower (4) comprising:
a body (7), and
a head (5) with a support surface (6) provided at a distal end of the head (5) and configured to support the respective workpiece (W) thereon, the support surface (6) being displaceable relative to the body (7) in a plane perpendicular to the axis,
**characterised in that** the body (7) comprises a pneumatic input to receive pressurised air and provide a lifting force to the head (5) to move it along the axis relative to the body (7), and
wherein each tower (4) comprises a locking mechanism for selectively locking the head (5) relative to the body (7).

2. Tooling (2) according to claim 1, wherein the head (5) comprises an elongate stem extending along the axis, and the body (7) comprises a sleeve having a central aperture dimensioned to slidingly receive the stem therein along the axis.

3. Tooling (2) according to claim 2, wherein the locking mechanism comprises an air bearing (13) arranged in the aperture adjacent to the stem, such that when an air supply is supplied to the air bearing (13), the stem may slide relative to the air bearing (13) parallel to the axis, and when the air supply is not supplied to the air bearing (13), the stem is locked relative to the air bearing (13).

4. A printer (1) for printing print medium onto a plurality of singulated workpieces (W) during a printing operation, comprising the tooling (2) of any preceding claim.

5. The printer (1) of claim 4, comprising a referencing plate (11) having a plurality of referencing surfaces (18) movable within a horizontal plane, each referencing surface (18) arranged to be movable into contact with a singulated workpiece (W) of the plurality of singulated workpieces (W) to align the singulated workpieces (W) within the horizontal plane in a horizontal referencing operation.

6. The printer (1) of claim 5, wherein the referencing plate (11) has an underside, which may be contacted by the singulated workpieces (W) in a vertical referencing operation.

7. The printer (1) of claim 6, wherein the referencing surfaces (18) are movable in the horizontal plane between an open configuration in which the singulated workpieces W, supported by the respective support surfaces (6), may enter respective apertures (17) provided in the referencing plate (11), and a closed configuration in which the apertures (17) are at least partially closed by the referencing surfaces (18).

8. The printer (1) of claim 7, wherein the underside of the referencing plate (11) is contactable by the singulated workpieces (W) in the vertical referencing operation only when the referencing surfaces (18) are in the closed configuration.

9. A method of referencing a plurality of singulated workpieces (W) within a printer (1) prior to performing a printing operation, the printer (1) comprising the tooling (2) of any of claims 1 to 3 for supporting the singulated workpieces (W) thereon and a referencing plate (11) having a plurality of referencing surfaces (18) movable within a horizontal plane, the method comprising the steps of:
i) supporting the workpieces (W) on the tooling (2) in a horizontal orientation, and
ii) performing, in any order, a vertical referencing operation and a horizontal referencing operation,
the vertical referencing operation comprising lifting the supported workpieces (W) into contact with an underside of the referencing plate (11), then locking the tooling (2) to retain the supported workpieces (W) at a locked vertical distance from a base of the tooling (2), and
the horizontal referencing operation comprising lifting the supported workpieces (W) into respective apertures (17) provided in the referencing plate (11) and moving the referencing surfaces (18) within the horizontal plane into contact with respective supported workpieces (W).

10. The method of claim 9, wherein the referencing surfaces (18) are movable in the horizontal plane between an open configuration in which the supported workpieces (W) may enter the respective apertures (17), and a closed configuration in which the apertures (17) are at least partially closed by the referencing surfaces (18).

11. The method of claim 10, wherein the vertical referencing operation comprises moving the referencing surfaces (18) to the closed configuration prior to lifting the supported workpieces (W) into contact with the underside of the referencing plate (11).

12. The method of either of claims 10 and 11, wherein the horizontal referencing operation comprises moving the referencing surfaces (18) to the open configuration prior to lifting the supported workpieces (W) into the respective apertures (17).

13. The method of any of claims 9 to 12, wherein the vertical referencing operation comprises lifting the supported workpieces (W) into contact with the underside of the referencing plate (11) sequentially.

14. The method of any of claims 9 to 13, comprising the step of lowering the tooling (2) following the vertical referencing operation, to bring the supported workpieces (W) away from the referencing plate (11).

## Patentansprüche

1. Werkzeug (2) zum Tragen einer Vielzahl von vereinzelten Werkstücken (W) während eines Druckvorgangs, wobei das Werkzeug (2) eine Vielzahl von Türmen (4) umfasst, wobei jeder Turm (4) sich entlang einer Achse erstreckt und dazu konfiguriert ist, ein jeweiliges Werkstück (W) der Vielzahl von Werkstücken (W) in einer horizontalen Orientierung zu tragen, wobei jeder Turm (4) Folgendes umfasst:
einen Körper (7), und
einen Kopf (5) mit einer Tragefläche (6), die an einem distalen Ende des Kopfes (5) bereitgestellt und dazu konfiguriert ist, das jeweilige Werkstück (W) darauf zu tragen, wobei die Tragefläche (6) relativ zu dem Körper (7) in einer Ebene senkrecht zu der Achse verfahrbar ist,
**gekennzeichnet dadurch, dass** der Körper (7) einen pneumatischen Eingang umfasst, um Druckluft zu empfangen und eine Hebekraft an den Kopf (5) bereitzustellen, um ihn entlang der Achse relativ zu dem Körper (7) zu bewegen, und
wobei jeder Turm (4) einen Verriegelungsmechanismus zum selektiven Verriegeln des Kopfes (5) relativ zu dem Körper (7) umfasst.

2. Werkzeug (2) nach Anspruch 1, wobei der Kopf (5) einen länglichen Schaft umfasst, der sich entlang der Achse erstreckt, und der Körper (7) eine Manschette umfasst, die eine zentrale Öffnung aufweist, die dazu dimensioniert ist, den Schaft entlang der Achse darin gleitend aufzunehmen.

3. Werkzeug (2) nach Anspruch 2, wobei der Verriegelungsmechanismus ein Luftlager (13) umfasst, das in der Öffnung benachbart zu dem Schaft angeordnet ist, sodass, wenn eine Luftzufuhr zu dem Luftlager (13) zugeführt wird, der Schaft relativ zu dem Luftlager (13) parallel zu der Achse gleiten kann, und, wenn die Luftzufuhr nicht zu dem Luftlager (13) zugeführt wird, der Schaft relativ zu dem Luftlager (13) verriegelt ist.

4. Drucker (1) zum Drucken eines Druckmediums auf eine Vielzahl von vereinzelten Werkstücken (W) während eines Druckvorgangs, umfassend das Werkzeug (2) nach einem der vorhergehenden Ansprüche.

5. Drucker (1) nach Anspruch 4, umfassend eine Referenzplatte (11), die eine Vielzahl von Referenzflächen (18) aufweist, die innerhalb einer horizontalen Ebene bewegbar sind, wobei jede Referenzfläche (18) dazu angeordnet ist, in einen Kontakt mit einem vereinzelten Werkstück (W) der Vielzahl von vereinzelten Werkstücken (W) bewegbar zu sein, um die vereinzelten Werkstücke (W) innerhalb der horizontalen Ebene in einem horizontalen Referenzvorgang auszurichten.

6. Drucker (1) nach Anspruch 5, wobei die Referenzplatte (11) eine Unterseite aufweist, die in einem vertikalen Referenzvorgang von den vereinzelten Werkstücken (W) kontaktiert werden kann.

7. Drucker (1) nach Anspruch 6, wobei die Referenzflächen (18) in der horizontalen Ebene bewegbar sind zwischen einer offenen Konfiguration, in der die vereinzelten Werkstücke (W), die von den jeweiligen Trageflächen (6) getragen werden, in jeweilige Öffnungen (17), die in der Referenzplatte (11) bereitgestellt sind, eintreten können, und einer geschlossenen Konfiguration, in der die Öffnungen (17) mindestens teilweise durch die Referenzflächen (18) geschlossen sind.

8. Drucker (1) nach Anspruch 7, wobei die Unterseite der Referenzplatte (11) in dem vertikalen Referenzvorgang nur von den vereinzelten Werkstücken (W) kontaktiert werden kann, wenn die Referenzflächen (18) in der geschlossenen Konfiguration sind.

9. Verfahren zum Referenzieren einer Vielzahl von vereinzelten Werkstücken (W) innerhalb eines Druckers (1) vor dem Durchführen eines Druckvorgangs, wobei der Drucker (1) das Werkzeug (2) nach einem der Ansprüche 1 bis 3 zum Tragen der vereinzelten Werkstücke (W) darauf und eine Referenzplatte (11), die eine Vielzahl von Referenzflächen (18) aufweist, die innerhalb einer horizontalen Ebene bewegbar sind, umfasst, wobei das Verfahren die folgenden Schritte umfasst:
i) Tragen der Werkstücke (W) auf dem Werkzeug (2) in einer horizontalen Orientierung, und
ii) Durchführen, in irgendeiner Reihenfolge, eines vertikalen Referenzvorgangs und eines horizontalen Referenzvorgangs,
wobei der vertikale Referenzvorgang das Heben der getragenen Werkstücke (W) in einen Kontakt mit einer Unterseite der Referenzplatte (11) umfasst, dann das Verriegeln des Werkzeugs (2), um die getragenen Werkstücke (W) in einer verriegelten vertikalen Distanz von einer Basis des Werkzeugs (2) zu halten, und
wobei der horizontale Referenzvorgang das Heben der getragenen Werkstücke (W) in jeweilige Öffnungen (17), die in der Referenzplatte (11) bereitgestellt sind, und das Bewegen der Referenzflächen (18) innerhalb der horizontalen Ebene in einen Kontakt mit jeweiligen getragenen Werkstücken (W) umfasst.

10. Verfahren nach Anspruch 9, wobei die Referenzflächen (18) in der horizontalen Ebene bewegbar sind zwischen einer offenen Konfiguration, in der die getragenen Werkstücke (W) in die jeweiligen Öffnungen (17) eintreten können, und einer geschlossenen Konfiguration, in der die Öffnungen (17) mindestens teilweise durch die Referenzflächen (18) geschlossen sind.

11. Verfahren nach Anspruch 10, wobei der vertikale Referenzvorgang das Bewegen der Referenzflächen (18) in die geschlossene Konfiguration umfasst, vor dem Heben der getragenen Werkstücke (W) in einen Kontakt mit der Unterseite der Referenzplatte (11).

12. Verfahren nach einem der Ansprüche 10 und 11, wobei der horizontale Referenzvorgang das Bewegen der Referenzflächen (18) in die offenen Konfiguration umfasst, vor dem Heben der getragenen Werkstücke (W) in die jeweiligen Öffnungen (17).

13. Verfahren nach einem der Ansprüche 9 bis 12, wobei der vertikale Referenzvorgang das sequenzielle Heben der getragenen Werkstücke (W) in einen Kontakt mit der Unterseite der Referenzplatte (11) umfasst.

14. Verfahren nach einem der Ansprüche 9 bis 13, umfassend den Schritt des Absenkens des Werkzeugs (2) anschließend an den vertikalen Referenzvorgang, um die getragenen Werkstücke (W) weg von der Referenzplatte (11) zu bringen.

## Revendications

1. Outillage (2) pour supporter une pluralité de pièces d'œuvre (W) individualisées pendant une opération d'impression, l'outillage (2) comprenant une pluralité de colonnes (4), chaque colonne (4) s'étendant le long d'un axe et étant configurée pour supporter une pièce d'œuvre (W) respective de la pluralité de pièces d'œuvre (W) dans une orientation horizontale, chaque colonne (4) comprenant :
un corps (7), et
une tête (5) avec une surface de support (6) prévue à une extrémité distale de la tête (5) et configurée pour supporter la pièce d'œuvre (W) respective sur celle-ci, la surface de support (6) étant déplaçable par rapport au corps (7) dans un plan perpendiculaire à l'axe,
**caractérisé en ce que** le corps (7) comprend une entrée pneumatique pour recevoir de l'air sous pression et fournir une force de levage à la tête (5) pour la déplacer le long de l'axe par rapport au corps (7), et
dans lequel chaque colonne (4) comprend un mécanisme de verrouillage permettant de verrouiller sélectivement la tête (5) par rapport au corps (7).

2. Outillage (2) selon la revendication 1, dans lequel la tête (5) comprend une tige allongée s'étendant le long de l'axe, et le corps (7) comprend un manchon présentant une ouverture centrale dimensionnée pour recevoir la tige en coulissement dans celui-ci le long de l'axe.

3. Outillage (2) selon la revendication 2, dans lequel le mécanisme de verrouillage comprend un palier à air (13) disposé dans l'ouverture, adjacent à la tige, de sorte que, lorsqu'un apport d'air est fourni au palier à air (13), la tige peut coulisser par rapport au palier à air (13) parallèlement à l'axe, et que, lorsqu'aucun apport d'air n'est fourni au palier à air (13), la tige est verrouillée par rapport au palier à air (13).

4. Imprimante (1) destinée à imprimer un matériau d'impression sur une pluralité de pièces d'œuvre (W) individualisées pendant une opération d'impression, comprenant l'outillage (2) de l'une quelconque des revendications précédentes.

5. Imprimante (1) selon la revendication 4, comprenant une plaque de référencement (11) présentant une pluralité de surfaces de référencement (18) mobiles au sein d'un plan horizontal, chaque surface de référencement (18) étant disposée pour être mobile afin d'entrer en contact avec une pièce d'œuvre (W) individualisée de la pluralité de pièces d'œuvre (W) individualisées afin d'aligner les pièces d'œuvre (W) individualisées au sein du plan horizontal lors d'une opération de référencement horizontal.

6. Imprimante (1) selon la revendication 5, dans laquelle la plaque de référencement (11) présente une face inférieure, qui peut être mise en contact avec les pièces d'œuvre (W) individualisées lors d'une opération de référencement vertical.

7. Imprimante (1) selon la revendication 6, dans laquelle les surfaces de référencement (18) sont mobiles dans le plan horizontal entre une configuration ouverte, dans laquelle les pièces d'œuvre W individualisées, supportées par les surfaces de support (6) respectives, peuvent pénétrer dans des ouvertures (17) respectives prévues dans la plaque de référencement (11), et une configuration fermée, dans laquelle les ouvertures (17) sont au moins partiellement fermés par les surfaces de référencement (18).

8. Imprimante (1) selon la revendication 7, dans laquelle la face inférieure de la plaque de référencement (11) peut être mise en contact avec les pièces d'œuvre (W) individualisées lors de l'opération de référencement vertical uniquement lorsque les surfaces de référencement (18) sont dans la configuration fermée.

9. Procédé de référencement d'une pluralité de pièces d'œuvre (W) individualisées au sein d'une imprimante (1) avant la mise en œuvre d'une opération d'impression, l'imprimante (1) comprenant l'outillage (2) de l'une quelconque des revendications 1 à 3 pour supporter les pièces d'œuvre (W) individualisées, et une plaque de référencement (11) présentant une pluralité de surfaces de référencement (18) mobiles au sein d'un plan horizontal, le procédé comprenant les étapes de :
i) soutien des pièces d'œuvre (W) sur l'outillage (2) dans une orientation horizontale, et
ii) mise en œuvre, dans un ordre quelconque, d'une opération de référencement vertical et d'une opération de référencement horizontal,
l'opération de référencement vertical comprenant le levage des pièces d'œuvre (W) supportées jusqu'à entrer en contact avec une face inférieure de la plaque de référencement (11), puis le verrouillage de l'outillage (2) afin de maintenir les pièces d'œuvre (W) supportées à une distance verticale verrouillée par rapport à une base de l'outillage (2), et
l'opération de référencement horizontal comprenant le levage des pièces d'œuvre (W) supportées jusque dans des ouvertures (17) respectives prévues dans la plaque de référencement (11) et le déplacement des surfaces de référencement (18) au sein du plan horizontal jusqu'à ce qu'elles entrent en contact avec les pièces d'œuvre (W) respectives supportées.

10. Procédé selon la revendication 9, dans lequel les surfaces de référencement (18) sont mobiles dans le plan horizontal entre une configuration ouverte, dans laquelle les pièces d'œuvre (W) supportées peuvent pénétrer dans les ouvertures (17) respectives, et une configuration fermée, dans laquelle les ouvertures (17) sont au moins partiellement fermées par les surfaces de référencement (18).

11. Procédé selon la revendication 10, dans lequel l'opération de référencement vertical comprend le déplacement des surfaces de référencement (18) vers la configuration fermée avant le levage des pièces d'œuvre (W) supportées jusqu'à entrer en contact avec la face inférieure de la plaque de référencement (11).

12. Procédé selon l'une quelconque des revendications 10 et 11, dans lequel l'opération de référencement horizontal comprend le déplacement des surfaces de référencement (18) vers la configuration ouverte avant le levage des pièces d'œuvre (W) supportées jusque dans les ouvertures (17) respectives.

13. Procédé selon l'une quelconque des revendications 9 à 12, dans lequel l'opération de référencement vertical comprend le levage séquentiel des pièces d'œuvre (W) supportées jusqu'à entrer en contact avec la face inférieure de la plaque de référencement (11).

14. Procédé selon l'une quelconque des revendications 9 à 13, comprenant l'étape de descente de l'outillage (2) après l'opération de référencement vertical, afin d'éloigner les pièces d'œuvre (W) supportées de la plaque de référencement (11).
